(19) Europäisches Patentamt
European Patent Office
Office européen des brevets

(11) EP 3 270 422 A1

(12) DEMANDE DE BREVET EUROPEEN

(43) Date de publication:
17.01.2018 Bulletin 2018/03

(51) Int Cl.:
H01L 31/042 (2014.01)    H01L 31/05 (2014.01)

(21) Numéro de dépôt: 17179429.0

(22) Date de dépôt: 03.07.2017

(84) Etats contractants désignés:
AL AT BE BG CH CY CZ DE DK EE ES FI FR GB GR HR HU IE IS IT LI LT LU LV MC MK MT NL NO PL PT RO RS SE SI SK SM TR
Etats d'extension désignés:
BA ME
Etats de validation désignés:
MA MD

(30) Priorité: 12.07.2016 FR 1601087

(71) Demandeur: Thales
92400 Courbevoie (FR)

(72) Inventeurs:
• D'ABRIGEON, Laurent
83440 Callian (FR)
• BOULANGER, Bernard
83600 Frejus (FR)

(74) Mandataire: Brunelli, Gérald
Marks & Clerk France
Immeuble Visium
22, avenue Aristide Briand
94117 Arcueil Cedex (FR)

(54) **CELLULE PHOTOVOLTAÏQUE ET PAVAGE ASSOCIÉ**

(57) Réseau de cellules photovoltaïques (8) alignées sur au moins une rangée (12, 13), de sorte que, dans une rangée de cellules (12, 13), la base d'une cellule (8) est alternativement sur un bord de la rangée (12, 13) puis sur l'autre bord de la rangée (12, 13), le cellules photovoltaïques (8) étant de forme en demi-hexagone régulier dont les alentours des sommets sont tronqués de sorte que la troncature (9) corresponde à une portion d'un demi-cercle (3) dont la base et diamètre est superposée et centrée sur la base du demi-hexagone, la base du demi-hexagone étant comprise entre 1 et $\frac{2}{\sqrt{3}}$ fois le diamètre du demi-cercle (3).

FIG.7

EP 3 270 422 A1

**Description**

L'invention porte sur une cellule photovoltaïque et un pavage associé.

La présente invention concerne les cellules et réseaux électriques photovoltaïques.

Une cellule photovoltaïque, également dénommée cellule solaire, est un composant électronique qui, exposé à la lumière (photons), produit de l'électricité grâce à l'effet photovoltaïque.

La puissance électrique obtenue est proportionnelle à la puissance lumineuse incidente sur la cellule photovoltaïque et à la surface de la cellule.

Les cellules photovoltaïques les plus utilisées sont à base de semi-conducteurs, principalement à base d'Arseniure de Gallium (AsGa).

Les cellules photovoltaïques sont produites sur un substrat, ou "wafer" en langue anglaise, qui est une structure cristalline nativement circulaire mais ensuite découpée suivant la géométrie souhaitée, appelée encore cellule native.

Les cellules photovoltaïques sont ensuite équipées d'interconnecteurs, recouvertes d'un verre de protection, ou "coverglass" en langue anglaise, et équipées d'une diode de protection à assembler à côté de la cellule photovoltaïque, dans la plupart des technologies.

Un réseau photovoltaïque est un assemblage ou pavage de cellules photovoltaïques qui sont pavées côte à côte. Un réseau optimal est donc construit à partir de formes élémentaires qui peuvent s'imbriquer (carrés, rectangles, hexagones...) afin d'éviter les pertes d'espace et pour avoir les meilleurs facteurs de conditionnement ou "packing factor" en langue anglaise, ou en d'autres termes les meilleurs rapports entre la surface de cellules photovoltaïques par rapport à la surface du support, ou compacité du pavage.

Les cellules native, i.e. circulaires, sont les plus économiques, car elles ne génèrent pas de déchets ou pertes de découpe, mais leur pavage est loin d'être optimal et laisse beaucoup de zones vides sur l'assemblage ou pavage ou panneau, conduisant à des surcoûts pour avoir des panneaux plus nombreux ou plus grands pour une puissance donnée.

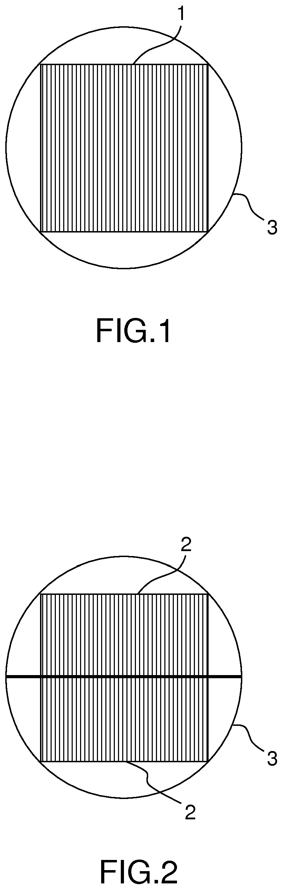

Le réseau ou pavage généralement choisi par les constructeurs actuels consiste souvent à prendre des cellules carrées 1, comme illustrées sur la figure 1, ou demi-carrées 2, comme illustrées sur la figure 2 (pour des raisons de procédé de fabrication, mais le principe reste identique), pour faire le réseau, et implique la perte d'une bonne partie de la cellule initialement produite 3 (nativement circulaire).

Pour des cellules photovoltaïques carrées 1 ou demi-carrées 2 on utilise 63 % de la cellule native circulaire 3, donc on en perd 37 %, et la compacité du pavage obtenu est de 100 %.

Ces cellules s'utilisent lorsque la diode de protection est intégrée. Dans le cas d'utilisation de diodes discrètes à poser à côté des cellules, la solution est d'utiliser des formes carrées ou demi-carrées à coin biseauté.

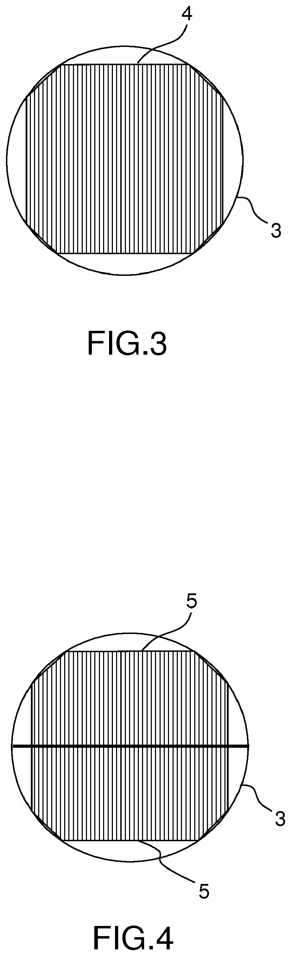

Enfin le compromis observé est généralement l'utilisation de cellules carrées 4, ou demi-carrées 5, à coins biseautés, comme illustrées respectivement sur les figures 3 et 4.

De telles cellules photovoltaïques 4, 5 permettent de limiter les pertes sur la cellule native circulaire 3, typiquement 10 à 18 % de perte et permettent d'obtenir un pavage avec un bon facteur de compacité, typiquement de l'ordre de 83 à 94 %, la partie laissée libre par le coin biseauté étant généralement utilisée pour positionner les diodes de protection permettant d'éviter que des cellules non éclairées, ou avec une défaillance se comportent comme des cellules réceptrices, dissipant la puissance générée par d'autres cellules.

Les diodes de protection ou diodes de "by-pass" en langue anglaise, permettent d'éviter cela, et sont connectées en parallèle de chaque cellule.

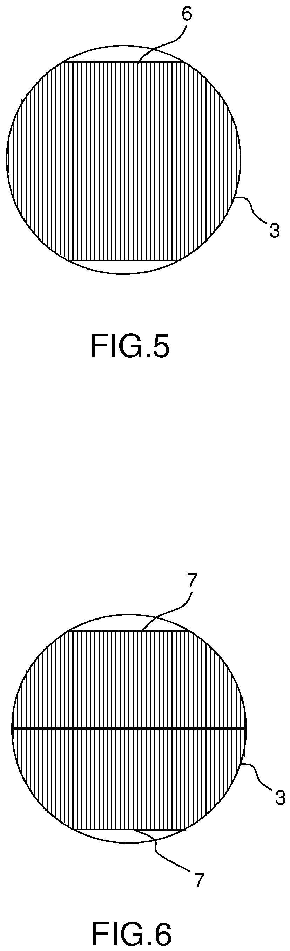

Il est également connu d'utiliser des cellules en forme de lune 6 ou de demi-lune 7 comme représentées respectivement sur les figures 5 et 6, qui permettent d'utiliser une plus grande partie de la cellule native circulaire 3.

De telles cellules photovoltaïques permettent de limiter les pertes sur la cellule native circulaire, typiquement 2 % de perte, mais ont un pavage avec un facteur de compacité limité, typiquement de l'ordre de 91 %, la partie laissée libre étant généralement utilisée pour positionner les diodes de protection.

Un but de l'invention est d'optimiser à la fois les pertes de découpe des cellules natives ou wafer, et la compacité du pavage des cellules obtenues.

Aussi, il est proposé, selon un aspect de l'invention, un réseau de cellules photovoltaïques alignées sur au moins une rangée, de sorte que, dans une rangée de cellules, la base d'une cellule est alternativement sur un bord de la rangée puis sur l'autre bord de la rangée, le cellules photovoltaïques étant de forme en demi-hexagone régulier dont les alentours des sommets sont tronqués de sorte que la troncature corresponde à une portion d'un demi-cercle dont la base et diamètre est superposée et centrée sur la base du demi-hexagone, la base du demi-hexagone étant comprise entre 1 et $\frac{2}{\sqrt{3}}$ fois le diamètre du demi-cercle.

Un tel pavage d'une telle cellule optimise à la fois les pertes de découpe des cellules natives ou wafer, et la compacité du pavage des cellules obtenues.

En effet, un tel pavage permet de limiter les pertes sur la cellule native circulaire, typiquement 3 % de perte et permettent d'obtenir un pavage avec un bon facteur de compacité, typiquement de l'ordre de 95 %, la partie laissée libre étant généralement utilisée pour positionner les diodes de protection.

Une telle forme de cellule photovoltaïque permet d'optimiser à la fois les pertes de découpe des cellules natives ou wafer de forme circulaire, et la compacité du pavage des cellules obtenues.

En outre, un seul design de cellule photovoltaïque suffit à réaliser un tel réseau, ce qui limite les coûts.

Selon un mode de réalisation, la base du demi-hexagone vaut 161.1 mm pour un substrat de 150 mm de diamètre.

Cette valeur est optimale.

Dans un mode de réalisation, le diamètre du demi-cercle est de 100 mm ou de 150 mm.

Un tel diamètre correspond à un diamètre classique de cellules photovoltaïques natives ou wafer, donc accessibles à coûts limités.

Dans un mode de réalisation, le réseau comprend des diodes de protection disposées entre des cellules du réseau dans les parties correspondant auxdites parties tronquées.

Les coins tronqués permettent donc à la fois d'augmenter l'utilisation du wafer et de positionner les diodes de protection.

Par exemple, la disposition des diodes de protection forme un motif régulier.

L'invention sera mieux comprise à l'étude de quelques modes de réalisation décrits à titre d'exemples nullement limitatifs et illustrés par les dessins annexés sur lesquels :

- la figure 1 illustre schématiquement la découpe d'une cellule photovoltaïque carrée dans une cellule photovoltaïque native, selon l'état de l'art;
- la figure 2 illustre schématiquement la découpe de deux cellules photovoltaïques demi-carrées dans une cellule photovoltaïque native, selon l'état de l'art;
- la figure 3 illustre schématiquement la découpe d'une cellule photovoltaïque carrée à coins biseautés dans une cellule photovoltaïque native, selon l'état de l'art;
- la figure 4 illustre schématiquement la découpe de deux cellules photovoltaïques demi-carrées à coins biseautés dans une cellule photovoltaïque native, selon l'état de l'art;
- la figure 5 illustre schématiquement la découpe d'une cellule photovoltaïque en forme de lune dans une cellule photovoltaïque native, selon l'état de l'art;
- la figure 6 illustre schématiquement la découpe de deux cellules photovoltaïques en forme de demi-lunes dans une cellule photovoltaïque native, selon l'état de l'art;
- la figure 7 illustre schématiquement la découpe de deux cellules photovoltaïques dans une cellule photovoltaïque native, selon un aspect de l'invention;
- la figure 8 illustre schématiquement les limites des demi-hexagones de troncature de deux cellules photovoltaïques dans une cellule photovoltaïque native, selon un aspect de l'invention; et
- la figure 9 illustre schématiquement un réseau ou pavage de cellules photovoltaïques, selon un aspect de l'invention.

Sur les différentes figures, les éléments ayant des références identiques sont identiques.

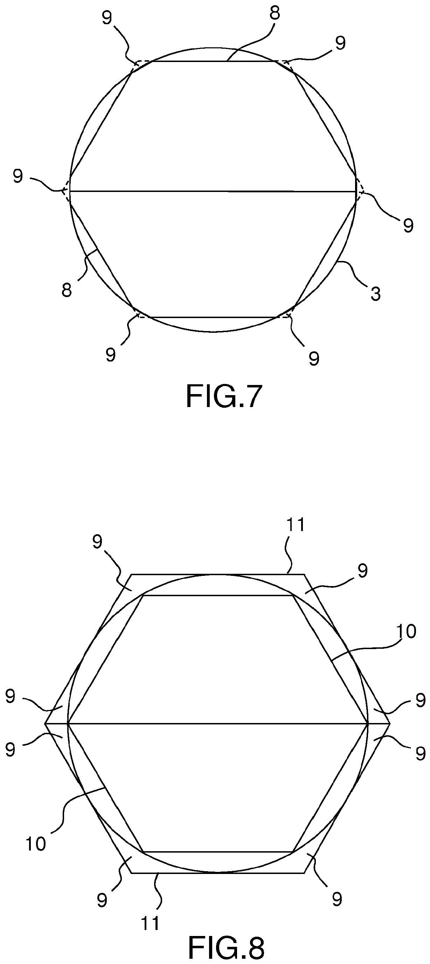

Sur la figure 7 est représentée une cellule native 3 circulaire dans laquelle sont découpées deux cellules photovoltaïques 8 selon un aspect de l'invention. La découpe de la cellule photovoltaïque native circulaire 3 est faite selon deux demi-hexagones tels que la base d'un demi-hexagone est alignée et centrée sur un diamètre de la cellule photovoltaïque native circulaire 3, la base du demi-hexagone étant comprise entre 1 fois et $\frac{2}{\sqrt{3}}$ fois le diamètre de la cellule photovoltaïque native circulaire 3. Ainsi, au final, chacune des deux cellules photovoltaïques selon un aspect de l'invention est de forme en demi-hexagone régulier dont les alentours des sommets sont tronqués de sorte que la troncature 9 corresponde à une portion d'un demi-cercle dont la base et diamètre est superposée et centrée sur la base du demi-hexagone, la base du demi-hexagone étant comprise entre 1 et $\frac{2}{\sqrt{3}}$ fois le diamètre du demi-cercle de la cellule photovoltaïque native circulaire 3.

La figure 8 illustre les demi-hexagones 10 et 11 dont les bases mesurent respectivement le diamètre et $\frac{2}{\sqrt{3}}$ fois le diamètre de la cellule photovoltaïque native circulaire 3.

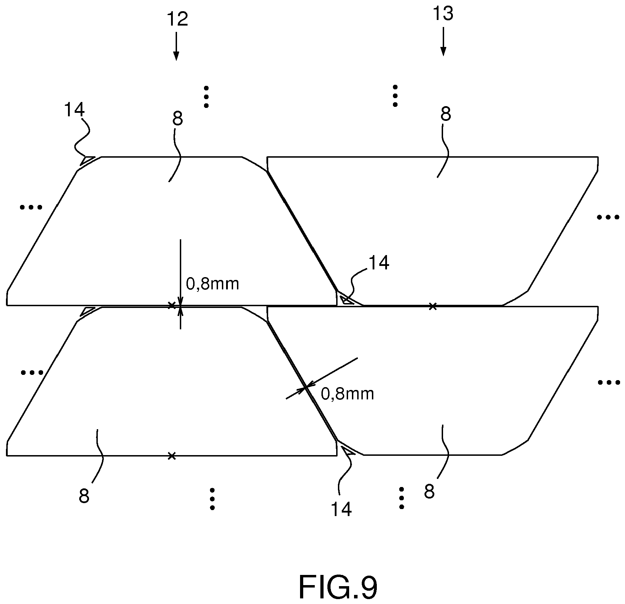

La figure 9 représente schématiquement une petite portion d'un réseau ou pavage de cellules 8 selon l'invention, sur laquelle est représentée uniquement deux cellules 8 respectivement sur deux colonnes 12 et 13 de cellules alignées adjacentes. Typiquement, les écarts entre deux cellules 8 du réseau et de 0,8 mm, comme représenté sur la figure 9. Pour deux colonnes adjacentes consécutives 12, et 13, la base des cellules d'une colonne 12 sont disposés en en bas des cellules 8, et inversement en haut des cellules 8 sur la colonne adjacente 13, et ainsi de suite.

Les espaces correspondant aux troncatures 9 permettent de disposer des diodes de protection 14.

En l'espèce, les diodes de protection 14 sont disposées dans la partie tronquée 9 d'un sommet de sorte que leur disposition forme un motif régulier.

Sur l'exemple illustré sur la figure 9, les diodes de protection sont disposées dans la partie tronquée d'un sommet n'appartenant pas à la base du demi-hexagone pour une colonne, et, pour une colonne adjacente, sur l'autre sommet n'appartenant pas à la base du demi-hexagone, et ainsi de suite.

Cette géométrie de cellule photovoltaïque 8 en demi-hexagone aux sommets arrondis permet d'avoir un réseau ou pavage associé qui maximise la taille de la cellule par rapport à la cellule native circulaire tout en ayant un taux de remplissage ou compacité du réseau associé excellent.

L'invention consiste à découper la cellule photovoltaïque en demi-hexagone à coins arrondis afin d'optimiser le "packing factor" ou compacité du pavage ou réseau de cellules et la découpe de la cellule et permet à la fois de profiter de découpes sur les bords du wafer qui sont de toute façon passivée et d'autoriser une petite perte de surface pour installer une diode de protection.

**Revendications**

1. Réseau de cellules photovoltaïques (8) alignées sur au moins une rangée (12, 13), de sorte que, dans une rangée de cellules (12, 13), la base d'une cellule (8) est alternativement sur un bord de la rangée (12, 13) puis sur l'autre bord de la rangée (12, 13), le cellules photovoltaïques (8) étant de forme en demi-hexagone régulier dont les alentours des sommets sont tronqués de sorte que la troncature (9) corresponde à une portion d'un demi-cercle (3) dont la base et diamètre est superposée et centrée sur la base du demi-hexagone, la base du demi-hexagone étant comprise entre 1 et $\dfrac{2}{\sqrt{3}}$ fois le diamètre du demi-cercle (3).

2. Réseau de cellules photovoltaïques (8) selon la revendication 1, dans lequel la base du demi-hexagone vaut 161.1 mm pour un diamètre de 150 mm.

3. Réseau de cellules photovoltaïques (8) selon la revendication 1 ou 2, dans lequel le diamètre du demi-cercle est de 100 mm ou de 150 mm.

4. Réseau de cellules photovoltaïques (8) selon l'une des revendications précédentes, comprenant des diodes (14) de protection disposées entre des cellules du réseau dans des parties correspondant auxdites parties tronquées (9).

5. Réseau de cellules photovoltaïques (8) selon la revendication 5, dans lequel la disposition des diodes de protection (14) forme un motif régulier.

FIG.1

FIG.2

FIG.3

FIG.4

FIG.5

FIG.6

FIG.7

FIG.8

FIG.9

Europäisches
Patentamt

European
Patent Office

Office européen
des brevets

# RAPPORT DE RECHERCHE EUROPEENNE

Numéro de la demande

EP 17 17 9429

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | JP S62 34451 U (SHARP CO., LTD) 28 février 1987 (1987-02-28) | 1 | INV. H01L31/042 H01L31/05 |
| Y | * figures 1,2 * * page 2 - page 5 * | 2-5 | |
| Y | JP 2001 094127 A (SHINETSU CHEMICAL CO) 6 avril 2001 (2001-04-06) * abrégé *; revendications 1-9; figures 6-13 * * alinéa [0006] - alinéa [0015] * * tableau 1 * | 1-5 | |
| Y | EP 1 816 684 A2 (SANYO ELECTRIC CO [JP]) 8 août 2007 (2007-08-08) * abrégé *; revendications 1-10; figures 11-13B * * alinéa [0003] - alinéa [0013] * | 1-5 | |
| A | JP H09 148601 A (SANYO ELECTRIC CO) 6 juin 1997 (1997-06-06) * abrégé *; revendications 1-5; figures 1-4 * | 1-5 | |

DOMAINES TECHNIQUES RECHERCHES (IPC)

H01L

Le présent rapport a été établi pour toutes les revendications

| Lieu de la recherche | Date d'achèvement de la recherche | Examinateur |
|---|---|---|
| Berlin | 1 août 2017 | Hamdani, Fayçal |

CATEGORIE DES DOCUMENTS CITES

X : particulièrement pertinent à lui seul
Y : particulièrement pertinent en combinaison avec un
   autre document de la même catégorie
A : arrière-plan technologique
O : divulgation non-écrite
P : document intercalaire

T : théorie ou principe à la base de l'invention
E : document de brevet antérieur, mais publié à la
   date de dépôt ou après cette date
D : cité dans la demande
L : cité pour d'autres raisons
...............................................................................................
& : membre de la même famille, document correspondant

EPO FORM 1503 03.82 (P04C02)

## ANNEXE AU RAPPORT DE RECHERCHE EUROPEENNE
### RELATIF A LA DEMANDE DE BREVET EUROPEEN NO.

EP 17 17 9429

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

01-08-2017

| Document brevet cité au rapport de recherche | | Date de publication | Membre(s) de la famille de brevet(s) | | Date de publication |
|---|---|---|---|---|---|
| JP S6234451 | U | 28-02-1987 | AUCUN | | |
| JP 2001094127 | A | 06-04-2001 | AUCUN | | |
| EP 1816684 | A2 | 08-08-2007 | CN | 101013731 A | 08-08-2007 |
| | | | EP | 1816684 A2 | 08-08-2007 |
| | | | US | 2007175509 A1 | 02-08-2007 |
| | | | US | 2012012152 A1 | 19-01-2012 |
| JP H09148601 | A | 06-06-1997 | JP | 3349318 B2 | 25-11-2002 |
| | | | JP | H09148601 A | 06-06-1997 |

EPO FORM P0460

Pour tout renseignement concernant cette annexe : voir Journal Officiel de l'Office européen des brevets, No.12/82